Europäisches Patentamt

European Patent Office

Office européen des brevets

(11) Publication number: **0 091 996**
**B1**

# (12) EUROPEAN PATENT SPECIFICATION

(45) Date of publication of patent specification: 25.03.87

(51) Int. Cl.⁴: **H 03 G 7/00**

(21) Application number: **82112038.3**

(22) Date of filing: **27.12.82**

(54) An electric circuit for detecting the maximum value of a plurality of input currents and a signal processing circuit employing it.

(30) Priority: **16.04.82 JP 62439/82**

(43) Date of publication of application:
**26.10.83 Bulletin 83/43**

(45) Publication of the grant of the patent:
**25.03.87 Bulletin 87/13**

(84) Designated Contracting States:
**DE FR GB IT**

(56) References cited:
**DE-A-2 425 938**
**DE-B-2 309 154**

**ELEKTOR, vol. 8, no. 2, February 1982, Beek,
Nederland, pages 41-45
IEEE TRANSACTIONS ON CONSUMER
ELECTRONICS, vol. CE-27, no. 4, November
1981 M. GILES et al. "A non-complementary
audio noise reduction system", pages 626-630
IEEE International Solid State Circuits
Conference Digest of Technical papers 1969,
pages 16, 17 M.J. HELLSTROM et al:
"Operational Amplifiers"**

(73) Proprietor: **Hitachi, Ltd.**
**5-1, Marunouchi 1-chome
Chiyoda-ku Tokyo 100 (JP)**

(72) Inventor: **Sato, Tetsuo**
**210-12, Shimosano-cho
Takasaki-shi Gumma (JP)**

(74) Representative: **Patentanwälte Beetz sen. -
Beetz jun. Timpe - Siegfried - Schmitt-Fumian
Steinsdorfstrasse 10
D-8000 München 22 (DE)**

Courier Press, Leamington Spa, England.

## Description

The present invention is directed to an electric circuit for detecting the maximum value of a plurality of input currents and a signal processing circuit employing it.

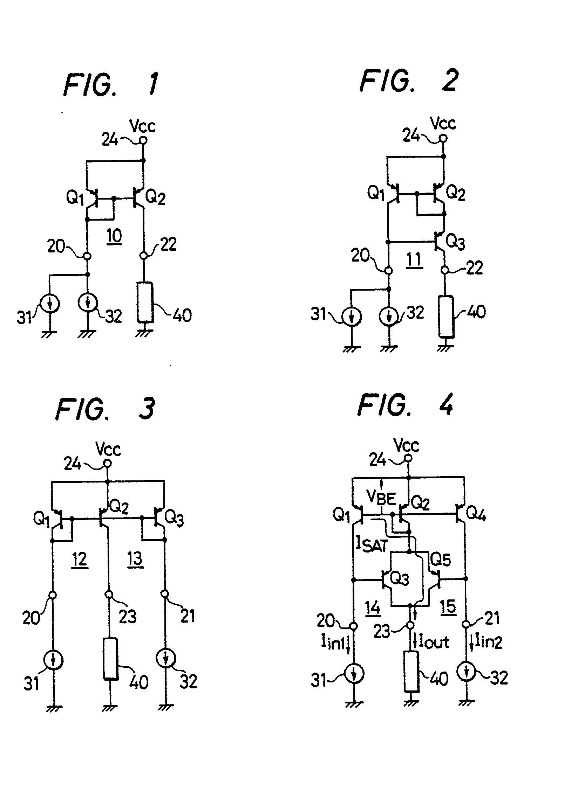

Figures 1 to 4 show electric circuits which were studied by the inventor prior to the present invention.

The electric circuit shown in Figure 1 or Figure 2 includes a current mirror circuit 10 or 11 which is constructed of PNP transistors $Q_1$, $Q_2$ or $Q_1$—$Q_3$ and which is well known to those in the art. A first current source 31 and a second current source 32 are connected to the input terminal 20 of the current mirror circuit 10 or 11, while a load 40 is connected to the output terminal 22 thereof. The power supply terminal 24 of the current mirror circuit 10 or 11 is supplied with a supply voltage $V_{cc}$.

The inventor's study, however, has revealed that, with the composite current mirror circuit of Figure 1 or Figure 2, in a case where the device characteristics of the PNP transistors $Q_1$ and $Q_2$ are equal to each other, an output current which is supplied from the output terminal 22 to the load 40 becomes the sum between a current flowing through the first current source 31 and a current flowing through the second current source 32, so the maximum value of the currents cannot be detected.

The composite current mirror circuit in Figure 3 includes a first current mirror circuit 12 which is constructed of PNP transistors $Q_1$ and $Q_2$, and a second current mirror circuit 13 which is constructed of PNP transistors $Q_2$ and $Q_3$. A first current source 31 is connected to the input terminal 20 of the first current mirror circuit 12, while a second current source 32 is connected to the input terminal 21 of the second current mirror circuit 13. A load 40 is connected to the common output terminal 23 of the first current mirror circuit 12 and the second current mirror circuit 13. A power supply terminal 24 is supplied with a supply voltage $V_{cc}$.

The inventor's study, however, has similarly revealed that, with the composite current mirror circuit of Figure 3, in a case where the device characteristics of the PNP transistors $Q_1$, $Q_2$ and $Q_3$ are equal to one another, an output current which is supplied from the output terminal 23 to the load 40 becomes half of the sum between a current flowing through the first current source 31 and a current flowing through the second current source 32, so the maximum value of the two currents cannot be detected.

The composite current mirror circuit in Figure 4 includes a first current mirror circuit 14 which is constructed of discrete PNP transistors $Q_1$—$Q_3$, and a second current mirror circuit 15 which is constructed of similar discrete PNP transistors $Q_2$—$Q_5$. A first current source 31 is connected to the input terminal 20 of the first current mirror circuit 14, while a second current source 32 is connected to the input terminal 21 of the second current mirror circuit 15. A load 40 is connected to the common output terminal 23 of the first current mirror circuit 14 and the second current mirror circuit 15. A power supply terminal 24 is supplied with a supply voltage $V_{cc}$.

The inventor's study, however, has revealed that, with the composite current mirror circuit of Figure 4, in a case where two input currents $I_{in1}$ and $I_{in2}$ have a difference, an accurate current comparing operation cannot be executed.

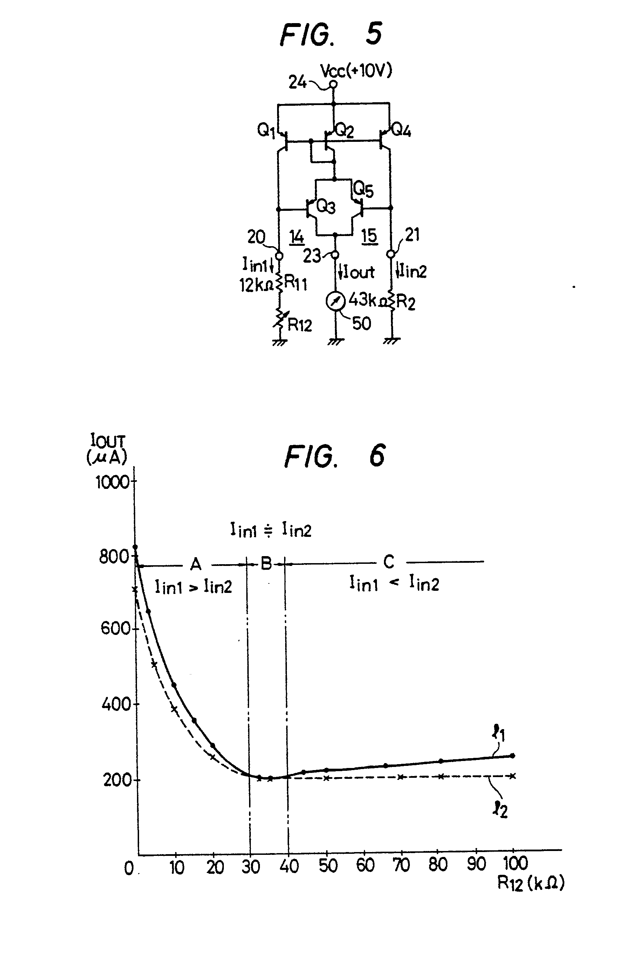

Figure 5 shows a measurement circuit for experimenting on the current comparing operation of the composite current mirror circuit of Figure 4. All the transistors $Q_1$—$Q_5$ are discrete PNP transistors. A fixed resistor $R_{11}$ of 12 kΩ and a variable resistor $R_{12}$ are connected in series to the first input terminal 20, a fixed resistor $R_2$ of 43 kΩ is connected to the second input terminal 21, and an ammeter 50 for measuring an output current $I_{out}$ is connected to the common output terminal 23. The first input current $I_{in1}$ is varied by changing the resistance value of the variable resistor $R_{12}$, whereas the second input current $I_{in2}$ becomes a constant current owing to the fixed resistor $R_2$.

Figure 6 is a graph which shows the experimental result of the composite current mirror circuit of Figure 4 obtained by the use of the measurement circuit of Figure 5.

In a region A in Figure 6, the resistance of the variable resistor $R_{12}$ is low, so that the first input current $I_{in1}$ becomes a value greater than that of the second input current $I_{in2}$, and the output current $I_{out}$ varies depending upon the first input current $I_{in1}$. In a region B in Figure 6, the sum between the resistances of the fixed resistor $R_{11}$ and the variable resistor $R_{12}$ is approximately equal to the resistance of the other fixed resistor $R_2$, so that the first input current $I_{in1}$ and the second input current $I_{in2}$ becomes values substantially equal to each other, and further, the output current $I_{out}$ becomes a value substantially equal to each of the above values. In a region C in Figure 6, the first input current $I_{in1}$ becomes a value smaller than that of the second input current $I_{in2}$ because of a high resistance of the variable resistor $R_{12}$. In the region C of Figure 6, accordingly, it is ideal for an electric circuit for detecting the maximum value of a plurality of currents, that the output current $I_{out}$ is unconditionally determined by the second input current $I_{in2}$ which is greater and constant. It has been revealed, nevertheless, that the composite current mirror circuit of Figure 4 has a characteristic $I_1$ deviating from the ideal state, particularly in the region C in Figure 6.

The inventor studied the cause of the above phenomenon, and has drawn a conclusion as described below.

In the region C of Figure 6 in which $I_{in1} < I_{in2}$ is satisfied, the base-emitter voltage $V_{BE}$ of each of the discrete PNP transistors $Q_1$, $Q_2$ and $Q_4$ in Figure 4 is obtained as follows in accordance with the greater current $I_{in2}$:

$$V_{BE} = \frac{KT}{q} \, 1n \, \frac{I_{in2}}{I_s} \qquad (1)$$

where K denotes Boltzmann's constant, T the absolute temperature, $q$ the magnitude of electronic charge, and $I_s$ a saturation current in the reverse direction.

Accordingly, the base-emitter junction of the transistor $Q_1$ is biased by the base-emitter voltage $V_{BE}$ determined by Equation (1), so that a current equal to the second input current $I_{in2}$ tends to flow through the emitter-collector path of the transistor. Since, however, the high resistance $R_{12}$ is connected to the collector of the transistor $Q_1$, the current to flow through the emitter-collector path thereof is limited to the smaller first input current $I_{in1}$. Thus, in the region C of Figure 6 which satisfies $I_{in1} < I_{in2}$, the discrete PNP transistor $Q_1$ in Figure 4 is driven into its saturation region, and hence, the collector-base junction thereof is forward-biased. A transistor saturation current $I_{SAT}$ based on the saturation of the transistor $Q_1$ flows through a path illustrated in Figure 4, and is supplied to the load 40 via the common output terminal 23.

Unless such transistor saturation current $I_{SAT}$ is supplied to the common output terminal, the output current $I_{OUT}$ will be unconditionally determined by the greater and constant second input current $I_{in2}$ under the condition of $I_{in1} < I_{in2}$. In actuality, however, the above transistor saturation current $I_{SAT}$ flows in the composite current mirror circuit of Figure 4, so that the deviation from the ideal state occurs in the region C of Figure 6.

Further, it has been similarly revealed that, in the region A of Figure 6 in which $I_{in1} > I_{in2}$ is fulfilled, the discrete PNP transistor $Q_4$ is driven into its saturation region, resulting in a deviation from an ideal state in the region A.

## Summary of the invention

In this manner, the present invention has been made on the basis of the results of study by the inventor as described above, and it has for its object to provide an electric circuit for detecting the maximum value of a plurality of input currents and/or a signal processing circuit employing it.

## Brief description of the drawings

Figures 1, 2, 3 and 4 show electric circuits which were studied by the inventor prior to the present invention;

Figure 5 shows a measurement circuit for experimenting on a circuit operation in Figure 4;

Figure 6 is a graph showing an experimental result obtained with the measurement circuit of Figure 5;

Figure 7 shows an equivalent circuit of an electric circuit according to an embodiment of the present invention;

Figure 8 is a sectional view of the essential portions of the semiconductor integrated circuit of the electric circuit according to the embodiment;

Figure 9 shows an equivalent circuit of an electric circuit according to a second embodiment of the present invention;

Figure 10 shows an equivalent circuit of an electric circuit according to a third embodiment of the present invention;

Figure 11 shows an equivalent circuit of an electric circuit according to a fourth embodiment of the present invention; and

Figures 12A and 12B are circuit diagrams of a signal processing circuit according to another embodiment of the present invention.

## Description of the preferred embodiments

Several embodiments according to the present invention will now be described with reference to the drawings.

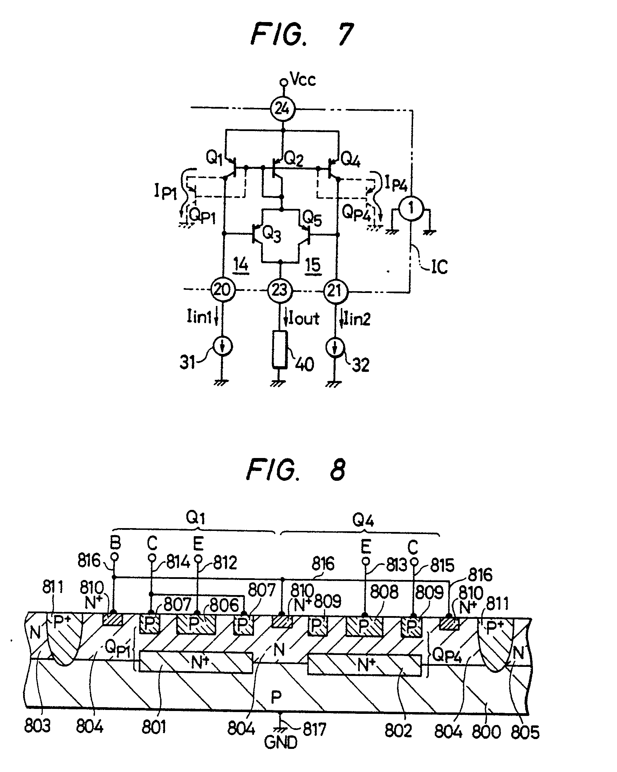

Figure 7 shows an equivalent circuit of an electric circuit for detecting the maximum value of a plurality of input currents, according to an embodiment of the present invention. Circuit elements inside a two-dot chain line IC are formed within the silicon chip of a monolithic semiconductor integrated circuit. Such electric circuit, that is, a composite current mirror circuit includes a first current mirror circuit 14 and a second current mirror circuit 15 which are constructed of lateral PNP transistors $Q_1—Q_5$ that are formed within the silicon chip. Terminals 20, 21, 23 and 24 are the external terminals of the semiconductor integrated circuit. A first current source 31 is connected to the input terminal 20 of the first current mirror circuit 14, a second current source 32 is connected to the input terminal 21 of the second current mirror circuit 15, a load 40 is connected to the common output terminal 23 of the first current mirror circuit 14 and the second current mirror circuit 15, and the power supply teminal 24 is fed with a supply voltage $V_{CC}$. Further, according to the present invention, parasitic PNP transistors $Q_{P1}$ and $Q_{P4}$ as additional transistors are respectively connected to the PNP transistors $Q_1$ and $Q_4$.

Figure 8 shows a sectional view of the essential portions of the semiconductor integrated circuit according to the embodiment. $N^+$-type buried layers 801 and 802 are formed in the top surface of a P-type silicon substrate 800, and N-type epitaxially grown layers 803, 804 and 805 are further formed thereon.

In the N-type epitaxially grown layer 804, there are formed a plurality of P-type impurity diffused layers 806, 807, 808 and 809 and an $N^+$-type impurity diffused layer 810.

In the surface of the N-type epitaxially grown layer 804, the P-type diffused layer 807 surrounds the P-type diffused layer 806 in the form of a ring, the P-type diffused layer 809 surrounds the P-type diffused layer 808 in the form of a ring, and the $N^+$-type diffused layer 810 surrounds these P-type diffused layers 806, 807, 808 and 809. Further, an isolation region 811 is formed in the N-type epitaxially grown layer 804 by P⁺-type diffusion.

Emitter electrodes 812 and 813 form ohmic contacts with the P-type diffused layers 806 and 808 respectively, collector electrodes 814 and 815 form ohmic contacts with the P-type diffused layers 807 and 809 respectively, and a base electrode 816 forms an ohmic contact with the N⁺-type diffused layer 810. An electrode 817 which forms an ohmic contact with the rear surface of the P-type substrate 800 is connected to an earth potential point.

Thus, the lateral PNP transistor $Q_1$ is formed of the P-type diffused layers 806, 807, N-type epitaxial layer 804 and N⁺-type diffused layer 810, while the lateral PNP transistor $Q_4$ is formed of the P-type diffused layers 808, 809, N-type epitaxial layer 804 and N⁺-type diffused layer 810.

To be specially mentioned is that the first parasitic PNP transistor $Q_{P1}$ as the additional transistor is formed of the P-type diffused layer 807, N-type epitaxial layer 804 and P-type substrate 800, while the second parasitic PNP transistor $Q_{P4}$ as the additional transistor is formed of the P-type diffused layer 809, N-type epitaxial layer 804 and P-type substrate 800. Equivalently, the emitters of the parasitic PNP transistors $Q_{P1}$ and $Q_{P4}$ are respectively connected to the collectors of the lateral PNP transistors $Q_1$ and $Q_4$, the bases of the parasitic PNP transistors $Q_{P1}$ and $Q_{P4}$ are respectively connected to the bases of the lateral PNP transistors $Q_1$ and $Q_4$, and the collectors of the parasitic PNP transistors $Q_1$ and $Q_4$ are connected to the earth potential point.

According to the embodiment of the present invention shown in Figures 7 and 8, the maximum value of a plurality of input currents can be detected with high precision for reasons described below.

In a case where the first input current $I_{in1}$ of the first current source 31 is greater than the second input current $I_{in2}$ of the second current source 32, there is a danger that the PNP transistor $Q_4$ receiving the smaller current $I_{in2}$ will be driven into its saturation region. In this case, as illustrated in Figure 7, at the same time that the collector-base junction of the PNP transistor $Q_4$ is forward-biased, the emitter-base junction of the parasitic PNP transistor $Q_{P4}$ is also forward-biased. Accordingly, the collector current $I_{P4}$ of the PNP transistor $Q_4$ flows to the earth potential point via the emitter-collector path of the parasitic PNP transistor $Q_{P4}$. Thus, in the case of $I_{in1} > I_{in2}$, it becomes possible to reduce the inflow of the transistor saturation current $I_{SAT}$ of the PNP transistor $Q_4$ to the load 40.

On the contrary, in a case of $I_{in1} < I_{in2}$, the PNP transistor $Q_1$ receiving the smaller current $I_{in1}$ is in danger of being driven into its saturation region. In this case, as illustrated in Figure 7, at the same time that the collector-base junction of the PNP transistor $Q_1$ is forward-biased, the emitter-base junction of the parasitic PNP transistor $Q_{P1}$ is also forward-biased. Accordingly, the collector current $I_{P1}$ of the PNP transistor $Q_1$ flows to the earth potential point via the emitter-collector path of the parasitic PNP transistor $Q_{P1}$. Thus, in the case of $I_{in1} < I_{in2}$, it becomes possible to reduce the inflow of the transistor saturation current $I_{SAT}$ of the PNP transistor $Q_1$ to the load 40.

The experimental result of the current comparing operation of the embodiment of the present invention shown in Figures 7 and 8, the result having been obtained with the measurement circuit of Figure 5, is indicated by a characteristic curve $I_2$ in Figure 6. It has been verified that the characteristic curve $I_2$ of Figure 6 agrees at very high precision with an ideal current comparing operation in the case where the base-emitter voltage $V_{BE}$ of each of the PNP transistor $Q_1$—$Q_5$ in the composite current mirror circuit of Figure 7 is 0.7 volt.

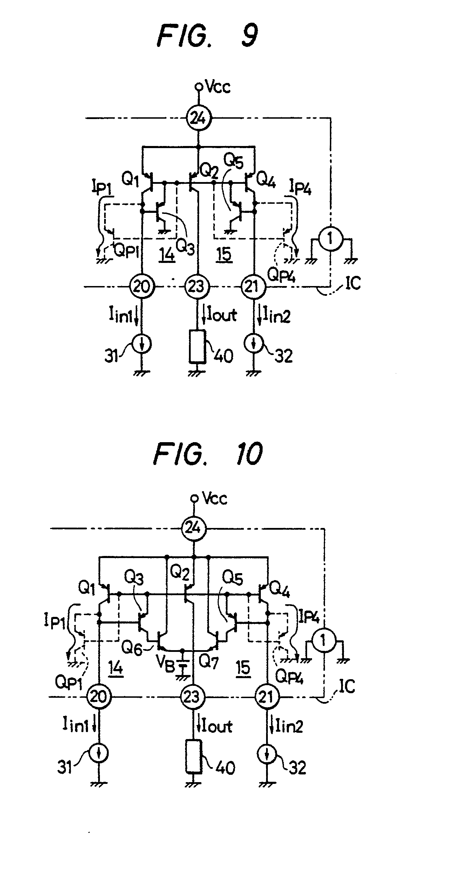

Figure 9 shows an equivalent circuit of an electric circuit for detecting the maximum value of a plurality of input currents, according to a second embodiment of the present invention. Circuit elements inside a two-dot chain line IC are formed within the silicon chip of a monolithic semiconductor integrated circuit. Transistors $Q_1$—$Q_5$ are lateral PNP transistors, and the collectors and bases of the respective PNP transistors $Q_1$, $Q_4$ are connected through the base-emitter junctions of the other PNP transistors $Q_3$, $Q_5$. Further, parasitic PNP transistors $Q_{P1}$, $Q_{P4}$ are equivalently connected to the respective PNP transistors $Q_1$, $Q_4$ as additional transistors. In particular, the PNP transistors $Q_1$, $Q_4$ and the parasitic PNP transistors $Q_{P1}$, $Q_{P4}$ are constructed as shown in the sectional view of Figure 8. As regards the others, the same parts as in Figure 7 are assigned the same reference numerals and will be omitted from description. Also with such embodiment, in the case of $I_{in1} > I_{in2}$ or $I_{in1} < I_{in2}$, the parasitic PNP transistor $Q_{P4}$ or $Q_{P1}$ turns "on" respectively, to permit reduction in the inflow of the transistor saturation current $I_{SAT}$ of the PNP transistor $Q_4$ or $Q_1$ to the load 40.

Figure 10 shows an equivalent circuit of an electric circuit for detecting the maximum value of a plurality of input currents, according to a third embodiment of the present invention. Circuit elements inside a two-dot chain line IC are formed within the silicon chip of a monolithic semiconductor integrated circuit. Transistors $Q_1$—$Q_5$ are lateral PNP transistors, while transistors $Q_6$, $Q_7$ are vertical NPN transistors. Especially different from the embodiment of Figure 9 is that the NPN transistors $Q_6$, $Q_7$ are respectively connected to the PNP transistors $Q_3$, $Q_5$ and that the emitters of both the transistors $Q_6$, $Q_7$ are supplied with a bias voltage $V_B$. Parasitic PNP transistors $Q_{P1}$, $Q_{P4}$ are equivalently connected to the respective PNP transistors $Q_1$, $Q_4$ as additional transistors. In particular, the PNP transistors $Q_1$, $Q_4$ and the parasitic PNP transistors $Q_{P1}$, $Q_{P4}$ are constructed as shown in the sectional view of Figure 8. Also with such embodiment, it is permitted in the case of $I_{in1} > I_{in2}$ or $I_{in1} < I_{in2}$ to reduce the inflow of the transistor saturation current $I_{SAT}$ to the load 40.

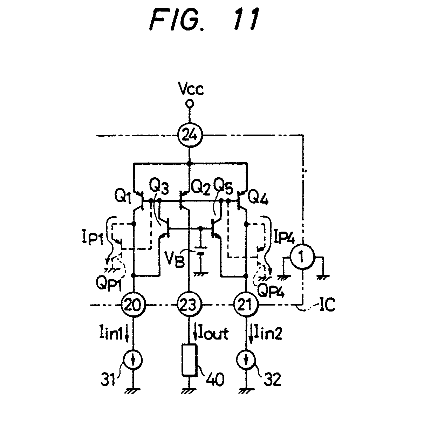

Figure 11 shows an equivalent circuit of an electric circuit for detecting the maximum value of a plurality of input currents, according to a fourth embodiment of the present invention. Circuit elements inside a two-dot chain line IC are formed within the silicon chip of a monolithic semiconductor integrated circuit. Transistors $Q_1$, $Q_2$ and $Q_4$ are lateral PNP transistors, while transistors $Q_3$ and $Q_5$ are vertical NPN transistors. The bases and collectors of the respective PNP transistors $Q_1$, $Q_4$ are connected through the collector-emitter paths of the NPN transistors $Q_3$, $Q_5$, and the bases of both the transistors $Q_3$, $Q_5$ are supplied with a bias voltage $V_B$. Parasitic PNP transistors $Q_{P1}$, $Q_{P4}$ are equivalently connected to the respective PNP transistors $Q_1$, $Q_4$ as additional transistors. In particular, the PNP transistors $Q_1$, $Q_4$ and the parasitic PNP transistors $Q_{P1}$, $Q_{P4}$ are constructed as shown in the sectional view of Figure 8. Also with such embodiment, it is permitted in the case of $I_{in1} > I_{in2}$ or $I_{in1} < I_{in2}$ to reduce the inflow of the transistor saturation current $I_{SAT}$ to the load 40.

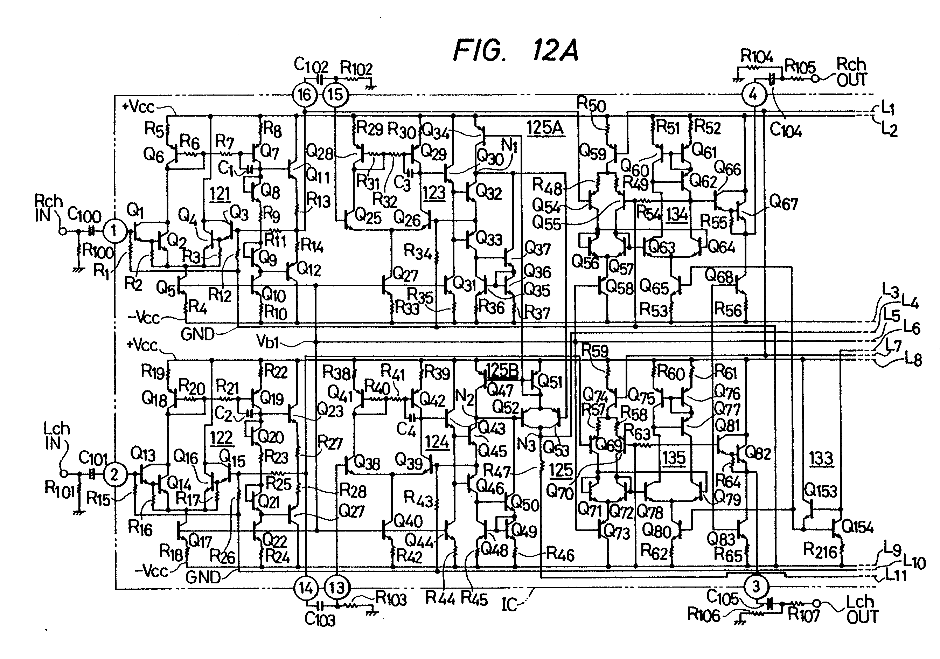

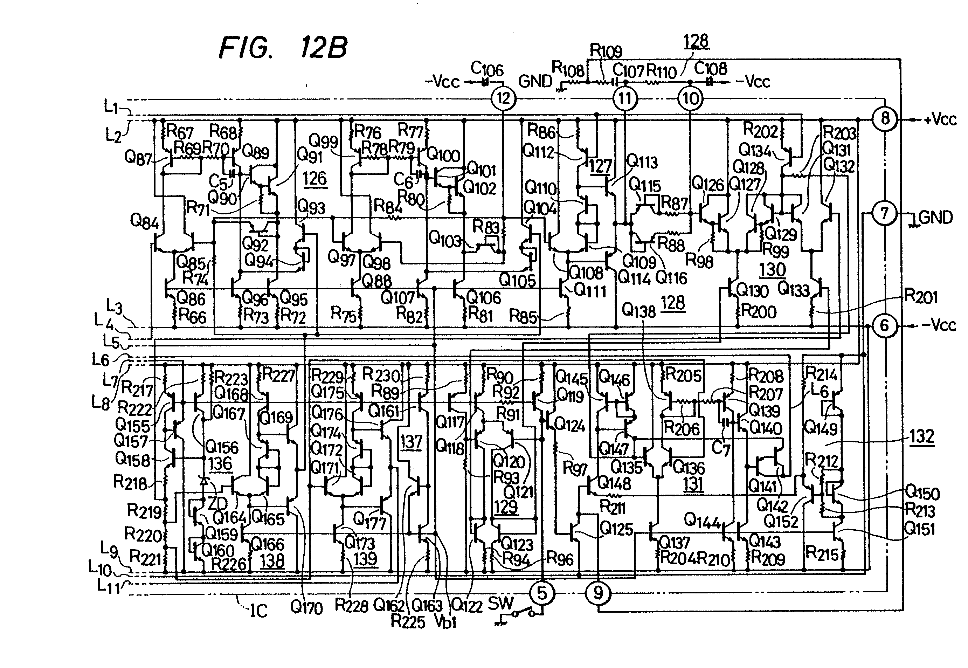

Figures 12A and 12B show circuit diagrams of a signal processing circuit according to another embodiment of the present invention. Such signal processing circuit is a CX (Compatible Expansion) type expander, and is effective for the noise reduction of a record of the audio system of an optical video disk.

The principle of such signal processing circuit as a noise reduction system is reported in IEEE Transactions on Consumer Electronics, November 1981, Volume CE-27, Number 4, pp. 626—630, and should be referred to.

The journal "Elektor", Vol. 8, No. 2, February 1982, Beek, Netherlands, pages 41 and 45 especially fig. 3 on page 2—44 discloses a compatible expansion type expander according to the preamble of claim 3. This compatible expansion type expander, however, cannot be easily integrated and does not use the electric circuit for detecting the maximum value of a plurality of input currents according to claim 1.

Circuit elements inside a two-dot chain line IC are formed within the silicon chip of a monolithic semiconductor integrated circuit, and the other circuit elements are constructed of discrete components.

A right channel audio input signal and a left channel audio input signal, which have been compressed by a CX type compressor, are respectively supplied to No. 1 terminal and No. 2 terminal through coupling capacitors $C_{100}$ and $C_{101}$ and are respectively amplified by a first input amplifier 121 and a second input amplifier 122.

The first input amplifier 121 is constructed of transistor $Q_1$—$Q_{12}$, resistors $R_1$—$R_{14}$ and a phase compensation capacitor $C_1$, while the second input amplifier 122 is constructed of transistors $Q_{13}$—$Q_{24}$, resistors $R_{15}$—$R_{28}$ and a phase compensation capacitor $C_2$.

The output signal of the first input amplifier 121 provided from No. 16 terminal is supplied through a coupling capacitor $C_{102}$ to No. 15 terminal which is the input terminal of a first full-wave rectifier 123, while the output signal of the second input amplifier 122 provided from No. 14 terminal is supplied through a coupling capacitor $C_{103}$ to No. 13 terminal which is the input terminal of a second full-wave rectifier 124.

The first full-wave rectifier 123 is constructed of transistors $Q_{25}$—$Q_{33}$ and $Q_{35}$—$Q_{37}$, resistors $R_{29}$—$R_{53}$ and a phase compensation capacitor $C_3$, thereby to provide a first full-wave rectification current at a node $N_1$. The second full-wave rectifier 124 is constructed of transistors $Q_{38}$—$Q_{46}$ and $Q_{48}$—$Q_{50}$, resistors $R_{38}$—$R_{46}$ and a phase compensation capacitor $C_4$, thereby to provide a second full-wave rectification current at a node $N_2$. Such full-wave rectifier is reported in detail in Japanese Laid-open Patent Application No. 52-123850, and should be referred to.

A maximum current detector 125 includes a first current mirror circuit 125A which is constructed of PNP transistors $Q_{34}$, $Q_{51}$ and $Q_{53}$, and a second current mirror circuit 125B which is constructed of PNP transistors $Q_{47}$, $Q_{51}$ and $Q_{52}$. A load resistor $R_{47}$ is connected to the common output terminal $N_3$ of the first current mirror circuit 125A and the second current mirror circuit 125B. The PNP transistors $Q_{34}$ and $Q_{47}$ are respectively formed as shown by the lateral PNP transistors $Q_1$ and $Q_4$ in the sectional view of Figure 8. As in each of the foregoing embodiments, therefore, parasitic PNP transistors are equivalently connected to the respective PNP transistors $Q_{34}$ and $Q_{47}$ as additional transistors. Accordingly, in a case where the first full-wave rectification current of the node $N_1$ is greater than the second full-wave rectification current of the node $N_2$, or in the converse case, either of the two parasitic PNP transistors turns "on", and the inflow of the transistor saturation current $I_{SAT}$ of the PNP transistors $Q_{34}$ or $Q_{47}$ to the load $R_{47}$ can be reduced.

A maximum current detection output signal having developed across the load $R_{47}$ is supplied through a wiring lead $L_4$ to the input of a peak detector 126 (the base of a transistor $Q_{84}$). Such peak detector 126 is constructed of transistors $Q_{84}$—$Q_{107}$, resistors $R_{66}$—$R_{84}$, phase compensation capacitors $C_5$ and $C_6$ and a peak holding capacitor $C_{106}$. A peak hold voltage is generated at No. 12 terminal.

This peak hold voltage produced at No. 12 terminal is transmitted to No. 11 terminal through a low output impedance buffer circuit 127 which is constructed of transistors $Q_{108}$—$Q_{114}$ and resistors $R_{85}$ and $R_{86}$.

Connected to No. 10 and No. 11 terminals is a time constant circuit 128 which is constructed of transistors $Q_{115}$ and $Q_{116}$, resistors $R_{87}$, $R_{88}$ and $R_{108}$—$R_{110}$ and capacitors $C_{107}$ and $C_{108}$. A rising time constant of about 30 msec is determined by the resistor $R_{87}$ and the capacitor $C_{108}$, while a decaying time constant of about 200 msec is determined by the resistor $R_{88}$ and the capacitor $C_{108}$.

A first control circuit 129, which is controlled by a control switch SW connected to No. 5 terminal, is constructed of transistors $Q_{117}$—$Q_{125}$ and resis-

tors $R_{89}$—$R_{97}$. When the control switch SW has become the "on" state, the transistor $Q_{120}$ of the first control circuit 129 falls into the "off" state, the transistor $Q_{121}$ into the "on" state and the transistors $Q_{124}$ and $Q_{125}$ into the "off" states. At this time, a transistor $Q_{130}$ falls into the "on" state and a transistor $Q_{133}$ into the "off" state in a switching type low output impedance buffer circuit 130 which is constructed of transistors $Q_{126}$—$Q_{134}$ and resistors $R_{98}$, $R_{99}$ and $R_{200}$—$R_{203}$. Accordingly, the voltage of No. 10 terminal is transmitted to the input terminal of a second control circuit 131 (the base of a transistor $Q_{135}$) through the transistors $Q_{126}$—$Q_{129}$ and resistor $R_{203}$ of the buffer circuit 130.

On the other hand, the second control circuit 131 is constructed of transistors $Q_{135}$—$Q_{148}$, resistors $R_{204}$—$R_{211}$ and a phase compensation capacitor $C_7$. A first bias circuit 132, which is constructed of transistors $Q_{149}$—$Q_{152}$ and resistors $R_{212}$—$R_{215}$, supplies a fixed voltage to a resistor $R_{211}$.

The capacitor $C_{107}$ and resistors $R_{108}$ and $R_{109}$, which are connected to No. 11 terminal, constitute a high-pass filter. The output signal of the high-pass filter at the common juncture of the resistors $R_{108}$ and $R_{109}$ is transmitted to the base of the transistor $Q_{148}$ through No. 9 terminal. Since the transistors $Q_{145}$—$Q_{147}$ connected to the collector of the transistor $Q_{148}$ constitute a current mirror circuit, the signal transmitted from No. 10 terminal and the signal transmitted from No. 11 terminal are added to each other at the input terminal of the second control circuit 131 (the base of the transistor $Q_{135}$). The addition signal is transmitted to the collector of the PNP transistor $Q_{141}$ as well as $Q_{142}$, and is further transmitted to a third control circuit 133 through a wiring lead $L_6$.

The third control circuit 133 is constructed of transistors $Q_{153}$ and $Q_{154}$ and a resistor $R_{216}$, and provides a control output signal from the emitter of the transistor $Q_{153}$.

A first variable gain amplifier 134 is constructed of transistors $Q_{54}$—$Q_{68}$ and resistors $R_{48}$—$R_{56}$, and its gain varies depending upon the collector current value of the transistor $Q_{65}$. Likewise, a second variable gain amplifier 135 is constructed of transistors $Q_{69}$—$Q_{83}$ and resistors $R_{57}$—$R_{65}$, and its gain varies depending upon the collector current value of the transistor $Q_{80}$.

Thus, the first variable gain amplifier 134 variably amplifies the output signal of the first input amplifier 121 at No. 16 terminal and transmits the amplifier signal to No. 4 terminal, while the second variable gain amplifier 135 variably amplifies the output signal of the second input amplifier 122 at No. 14 terminal and transmits the amplified signal to No. 3 terminal. It is therefore possible to obtain a right channel audio output signal and a left channel audio output signal which have been expanded by the signal processing circuit functioning as the CX type expander.

A second bias circuit 136 is constructed of transistors $Q_{155}$—$Q_{160}$, a Zener diode ZD and resistors $R_{217}$—$R_{223}$, and generates a plurality of bias voltages.

A third bias circuit 137 is constructed of transistors $Q_{161}$—$Q_{163}$ and resistors $R_{224}$ and $R_{225}$, and generates a bias voltage $V_{b1}$ at the base of the transistors $Q_{163}$.

A buffer circuit 138, which is constructed of transistors $Q_{164}$—$Q_{170}$ and resistors $R_{226}$ and $R_{227}$, transmits the bias voltage at the common juncture of the resistors $R_{219}$ and $R_{220}$ to the emitters of the transistors $Q_{169}$ and $Q_{170}$ with a low output impedance. A buffer circuit 139, which is constructed of transistors $Q_{171}$—$Q_{177}$ and resistors $R_{228}$ and $R_{229}$, transmits the bias voltage at the common juncture of the resistors $R_{220}$ and $R_{221}$ to the emitters of the transistors $Q_{176}$ and $Q_{177}$ with a low output impedance.

Accordingly, in the case where the signal processing circuit operates as the CX type expander, the gain of the first variable gain amplifier 134 and that of the second variable gain amplifier 135 are simultaneously determined by either greater one of the first full-wave rectification current of the node $N_1$ and the second full-wave rectification current of the node $N_2$. It is therefore possible to provide a CX type expander of high precision.

When the control switch SW connected to No. 5 terminal has become the "off" state, the transistor $Q_{120}$ of the first control circuit 129 falls into the "on" state, the transistor $Q_{121}$ into the "off" state and the transistors $Q_{124}$ and $Q_{125}$ into the "on" states. Then, such signal processing circuit stops the operation as the CX type expander.

The respective embodiments of the present invention described above can adopt various modified aspects of performance within the common knowledge of those skilled in the art.

By way of example, it is obvious that the electric circuit according to any of the embodiments in Figures 7, 9, 10 and 11 can be utilized as the maximum current detector 125 in Figure 12A.

## Claims

1. An electric circuit for detecting the maximum value of a plurality of input currents, characterized in that it comprises
a) a first current mirror circuit (14; 125A) having a first input transistor ($Q_1$; $Q_{34}$), a first coupling transistor ($Q_3$; $Q_{53}$) and an output transistor ($Q_2$; $Q_{51}$), wherein an emitter of said first input transistor ($Q_1$; $Q_{34}$) and an emitter of said output transistor ($Q_2$; $Q_{51}$) are connected, a base of said first input transistor ($Q_1$; $Q_{34}$) and a base of said output transistor ($Q_2$; $Q_{51}$) are connected, a collector and the base of said first input transistor ($Q_1$; $Q_{34}$) are connected through said first coupling transistor ($Q_3$; $Q_{53}$), a first input terminal (20; $N_1$) is connected to the collector of said first input transistor ($Q_1$; $Q_{34}$), and an output terminal (23; $N_3$) is connected to a collector of said output transistor ($Q_2$; $Q_{512}$); and
b) a second current mirror circuit (15; 125B) having a second input transistor ($Q_4$; $Q_{47}$), a second coupling transistor ($Q_5$; $Q_{52}$) and the output transistor ($Q_2$; $Q_{51}$), wherein an emitter of said second input transistor ($Q_4$; $Q_{47}$) and the emitter of said output transistor ($Q_2$; $Q_{51}$) are connected, a base of said second input transistor ($Q_4$; $Q_{47}$) and the base of said output transistor ($Q_2$; $Q_{51}$) are connected, a collector and the base of said second input transistor ($Q_4$; $Q_{47}$) are connected through said second coupling transistor ($Q_5$; $Q_{52}$), a second input terminal (21; $N_2$) is connected to the collector of said second input transistor ($Q_4$; $Q_{47}$), and said second current mirror circuit (15; 125B) has an output terminal (23; $N_3$) common to said output terminal of said first current mirror circuit (14; 125A); said first current mirror circuit (14; 125A) further having a first additional transistor ($Q_{P1}$) whose emitter, base and collector are respectively connected to the collector and base of said first input transistor ($Q_1$; $Q_{34}$) and a reference potential, while said second current mirror circuit (15; 125B) further has a second additional transistor ($Q_{P4}$) whose emitter, base and collector are respectively connected to the collector and base of said second input transistor ($Q_4$; $Q_{47}$) and the reference potential;

said first input terminal (20; $N_1$) being supplied with a first input current ($I_{in1}$) and said second input terminal (21; $N_2$) with a second input current ($I_{in2}$), whereby an output current ($I_{OUT}$) proportional to either greater value of the two input currents ($I_{in1}$, $I_{in2}$) is provided from said common output terminal (23; $N_3$).

2. An electric circuit according to claim 1, wherein the base of said first input transistor ($Q_1$; $Q_{34}$) and the base of said second input transistor ($Q_4$; $Q_{47}$) are formed of an N-type semiconductor layer (804) on a P-type semiconductor substrate (800), and the collector of said first input transistor ($Q_1$; $Q_{34}$) and the collector of said second input transistor ($Q_4$; $Q_{47}$) are respectively formed of a first P-type semiconductor layer (807) and a second P-type semiconductor layer (809) which are formed within said N-type semiconductor layer (804); with the result that equivalently the emitter of said first additional transistor ($Q_{P1}$) is formed of said first P-type semiconductor layer (807), that equivalently the emitter of said second additional transistor ($Q_{P4}$) is formed of said second P-type semiconductor layer (809), that equivalently the base of said first additional transistor ($Q_{P1}$) and the base of said second additional transistor ($Q_{P4}$) are formed of said N-type semiconductor layer (804), and that equivalently the collector of said first additional transistor ($Q_{P1}$) and the collector of said second additional transistor ($Q_{P4}$) are formed of said P-type semiconductor substrate (800).

3. A compatible expansion type expander comprising:

(a) a first input amplifier (121) for amplifying a first input signal;

(b) a second input amplifier (122) for amplifying a second input signal;

(c) a first rectifier (123) for producing a first rectified current from an A.C. output signal of said first input amplifier (121);

(d) a second rectifier (124) for producing a second rectified current from an A.C. output signal of said second input amplifier (122);

(e) a maximum current detector (125) for producing an output signal which is proportional to either greater value of the first and second rectified currents;

(f) a peak detector (126) whose input terminal is connected to an output terminal of said maximum current detector (125);

(g) a time constant circuit (128) whose input terminal is connected to an output terminal of said peak detector (126);

(h) a first variable gain amplifier circuit (134) which is so constructed that its input terminal is supplied with the output signal of said first input amplifier (121), and its gain is controlled by an output signal of said time constant circuit (128), whereby a first expanded output signal is provided from its output terminal; and

(i) a second variable gain amplifier circuit (135) which is so constructed that its input terminal is supplied with the output signal of said second input amplifier (122), and its gain is controlled by the output signal of said time constant circuit (128), whereby a second expanded output signal is provided from its output terminal; characterized in that said maximum current detector (125) is a circuit according to claim 1 or 2, whereby said first input terminal ($N_1$) is supplied with the first rectified current, while said second input terminal ($N_2$) is supplied with the second rectified current.

**Patentansprüche**

1. Elektrische Schaltung zur Ermittlung des Maximalwerts mehrerer Eingangsströme, dadurch gekennzeichnet, daß sie aufweist

a) eine erste Stromspiegelschaltung (14; 125A), die einen ersten Eingangstransistor ($Q_1$; $Q_{34}$), einen ersten Koppeltransistor ($Q_3$; $Q_{53}$) und einen Ausgangstransistor ($Q_2$; $Q_{51}$) besitzt, wobei ein Emitter des ersten Eingangstransistors ($Q_1$; $Q_{34}$) mit einem Emitter des Ausgangstransistors ($Q_2$; $Q_{51}$), eine Basis des ersten Eingangstransistors mit einer Basis des Ausgangstransistors ($Q_2$; $Q_{51}$), ein Kollektor und die Basis des ersten Eingangstransistors ($Q_1$; $Q_{34}$) durch den ersten Koppeltransistor ($Q_3$; $Q_{53}$), ein erster Eingangsanschluß (20; $N_1$) mit dem Kollektor des ersten Eingangstransistors ($Q_1$; $Q_{34}$) und ein Ausgangsanschluß (23; $N_3$) mit einem Kollektor des Ausgangstransistors ($Q_2$; $Q_{51}$) verbunden sind; und

b) eine zweite Stromspiegelschaltung (15; 125B), die einen zweiten Eingangstransistor ($Q_4$; $Q_{47}$), einen zweiten Koppeltransistor ($Q_5$; $Q_{52}$) und den Ausgangstransistor ($Q_2$; $Q_{51}$) besitzt, wobei ein Emitter des zweiten Eingangstransistors ($Q_4$; $Q_{47}$) mit dem Emitter des Ausgangstransistors ($Q_2$; $Q_{51}$), eine Basis des zweiten Eingangstransistors ($Q_4$; $Q_{47}$) mit der Basis des Ausgangstransi-

stors ($Q_2$; $Q_{51}$), ein Kollektor mit der Basis des zweiten Eingangstransistors ($Q_4$; $Q_{47}$) durch den zweiten Koppeltransistor ($Q_5$; $Q_{52}$), und ein zweiter Eingangsanschluß (21; $N_2$) mit dem Kollektor des zweiten Eingangstransistors ($Q_4$; $Q_{47}$) verbunden sind, und wobei die zweite Stromspiegelschaltung (15; 125B) einen Ausgangsanschluß (23; $N_3$) gemeinsam mit dem Ausgangsanschluß der ersten Stromspiegelschaltung (14; 125A) hat; die erste Stromspiegelschaltung (14; 125A) außerdem einen ersten zusätzlichen Transistor ($Q_{P1}$), der mit seinem Emitter, seiner Basis und seinem Kollektor jeweils mit dem Kollektor und der Basis des ersten Eingangstransistors ($Q_1$; $Q_{34}$) und mit einem Bezugspotential verbunden sind, während die zweite Stromspiegelschaltung (15; 125B) außerdem einen zweiten zusätzlichen Transistor ($Q_{P4}$) aufweist, dessen Emitter, Basis und Kollektor jeweils mit dem Kollektor und der Basis des zweiten Eingangstransistors ($Q_4$; $Q_{47}$) und mit dem Bezugspotential verbunden sind; der erste Eingangsanschluß (20; $N_1$) mit einem ersten Eingangsstrom ($I_{in1}$), und der zweite Eingangsanschluß (21; $N_2$) mit einem zweiten Eingangsstrom ($I_{in2}$) versorgt werden, wobei ein Ausgangsstrom ($I_{OUT}$) proportional zum jeweils größeren Wert der zwei Eingangsströme ($I_{in1}$; $I_{in2}$) vom gemeinsamen Ausgangsanschluß (23; $N_3$) geliefert wird.

2. Elektrische Schaltung nach Anspruch 1, dadurch gekennzeichnet, daß die Basis des ersten Eingangstransistors ($Q_1$; $Q_{34}$) und die Basis des zweiten Eingangstransistors ($Q_4$; $Q_{47}$) durch eine N-Halbleiterschicht (804) auf einem P-Halbleitersubstrat (800), und der Kollektor des ersten Eingangstransistors ($Q_1$; $Q_{34}$) und der Kollektor des zweiten Eingangstransistors ($Q_4$; $Q_{47}$) jeweils durch eine erste P-Halbleiterschicht (807) und eine zweite P-Halbleiterschicht (809) gebildet werden, die innerhalb der N-Halbleiterschicht (804) ausgebildet sind; mit dem Ergebnis, daß äquivalent der Emitter des ersten zusätzlichen Transistors ($Q_{P1}$) durch die erste P-Halbleiterschicht (807), äquivalent der Emitter des zweiten zusätzlichen Transistors ($Q_{P4}$) durch die zweite P-Halbleiterschicht (809), äquivalent die Basis des ersten zusätzlichen Transistors ($Q_{P1}$) und die Basis des zweiten zusätzlichen Transistors ($Q_{P4}$) durch die N-Halbleiterschicht (804) und äquivalent der Kollektor des ersten zusätzlichen Transistors ($Q_{P1}$) und der Kollektor des zweiten zusätzlichen Transistors ($Q_{P4}$) durch das P-Halbleitersubstrat (800) gebildet werden.

3. Expander-Schaltung vom kompatiblen Dehnungstyp mit

a) einem ersten Eingangsverstärker (121), der ein erstes Eingangssignal verstärkt;

b) einem zweiten Eingangsverstärker (122), der ein zweites Eingangssignal verstärkt;

c) einem ersten Gleichrichter (123), der einen ersten gleichgerichteten Strom aus einem Wechselstromausgangssignal des ersten Eingangsverstärkers (121) erzeugt;

d) einem zweiten Gleichrichter (124), der einen zweiten gleichgerichteten Strom von einem Wechselstromausgangssignal des zweiten Eingangsverstärkers (122) erzeugt;

e) einem Maximalstromdetektor (125), der ein Ausgangssignal erzeugt, das dem jeweils größeren Wert des ersten und zweiten gleichgerichteten Stromes proportional ist;

f) einem Spitzenwertdetektor (126), dessen Eingangsanschluß mit einem Ausgangsanschluß des Maximalstromdetektors (125) verbunden ist;

g) einer Zeitkonstanten-Schaltung (128), deren Eingangsanschluß mit einem Ausgangsanschluß des Spitzenwertdetektors (126) verbunden ist;

h) einer ersten Verstärkerschaltung (134) mit änderbarer Verstärkung, die so aufgebaut ist, daß ihr Eingangsanschluß das Ausgangssignal des ersten Eingangsverstärkers (121) erhält und deren Verstärkungsgrad durch ein Ausgangssignal der Zeitkonstanten-Schaltung (128) gesteuert wird, wodurch ein erstes expandiertes Ausgangssignal vom Ausgangsanschluß der Verstärkerschaltung (134) abgegeben wird; und

i) einer zweiten Verstärkerschaltung (135) mit änderbarer Verstärkung, die so aufgebaut ist, daß ihr Eingangsanschluß das Ausgangssignal des zweiten Eingangsverstärkers (122) erhält und deren Verstärkungsgrad durch das Ausgangssignal der Zeitkonstanten-Schaltung (128) gesteuert wird, wodurch ein zweites expandiertes Ausgangssignal an ihrem Ausgangsanschluß abgegeben wird;
dadurch gekennzeichnet, daß
der Maximalstromdetektor (125) eine Schaltung nach Anspruch 1 oder 2 ist, wobei der erste Eingangsanschluß ($N_1$) mit dem ersten gleichgerichteten Strom während der zweite Eingangsanschluß ($N_2$) mit dem zweiten gleichgerichteten Strom gespeist werden.

**Revendications**

1. Circuit électrique servant à détecter la valeur maximale d'une pluralité de courants d'entrée, caractérisé en ce qu'il comporte

a) un premier circuit formant miroir de courant (14; 125A) comportant un premier transistor d'entrée ($Q_1$; $Q_{34}$), un premier transistor de couplage ($Q_3$; $Q_{53}$) et un transistor de sortie ($Q_2$; $Q_{51}$), et dans lequel un émetteur dudit premier transistor d'entrée ($Q_1$; $Q_{34}$) et un émetteur dudit transistor de sortie ($Q_2$; $Q_{51}$) sont raccordés, une base dudit premier transistor d'entrée ($Q_1$; $Q_{34}$) et une base dudit transistor de sortie ($Q_2$; $Q_{51}$) sont raccordées, un collecteur et la base dudit premier transistor d'entrée ($Q_1$; $Q_{34}$) sont raccordés par l'intermédiaire du premier transistor de couplage ($Q_3$; $Q_{53}$), une première borne d'entrée (20; $N_1$) est raccordée au collecteur dudit premier transistor d'entrée ($Q_1$; $Q_{34}$), et une borne de sortie (23; $N_3$) est raccordée à un collecteur dudit transistor de sortie ($Q_2$; $Q_{51}$); et

b) un second circuit formant miroir de courant (15, 125B) comportant un second transistor d'entrée ($Q_4$; $Q_{47}$), un second transistor de couplage ($Q_5$; $Q_{52}$) et le transistor de sortie ($Q_2$; $Q_{51}$), et dans lequel un émetteur dudit second transistor

d'entrée ($Q_4$; $Q_{47}$) et l'émetteur du transistor de sortie ($Q_2$; $Q_{51}$) sont raccordés, une base dudit second transistor d'entrée ($Q_4$; $Q_{47}$) et la base dudit transistor de sortie ($Q_2$; $Q_{51}$) sont raccordées, un collecteur et la base dudit second transistor d'entrée ($Q_4$; $Q_{47}$) sont raccordés par l'intermédiaire dudit second transistor de couplage ($Q_5$; $Q_{52}$), une seconde borne d'entrée (21; $N_2$) est raccordée au collecteur dudit second transistor d'entrée ($Q_4$; $Q_{47}$), et ledit second circuit formant miroir de courant (15; 125B) possède une borne de sortie (23; $N_3$) commune avec ladite borne de sortie du dit premier circuit formant miroir de courant (14; 125A);

— ledit premier circuit formant miroir de courant (14; 125A) comportant en outre un premier transistor additionnel ($Q_{P1}$), dont l'émetteur, la base et le collecteur sont raccordés respectivement au collecteur et à la base dudit premier transistor d'entrée ($Q_1$; $Q_{34}$) et à un potentiel de référence, tandis que le second circuit formant miroir de courant (15; 125B) comporte en outre un second transistor additionnel ($Q_{P4}$), dont l'émetteur, la base et le collecteur sont raccordés respectivement au collecteur et à la base du second transistor d'entrée ($Q_4$; $Q_{47}$) et au potentiel de référence;

— ladite première borne d'entrée (20; $N_1$) étant alimentée par un premier courant d'entrée ($I_{in1}$) et ladite seconde borne d'entrée (21; $N_2$) étant alimentée par un second courant d'entrée ($I_{in2}$), ce qui a pour effet qu'un courant de sortie ($I_{OUT}$) proportionnel à celui des deux courants d'entrée ($I_{in1}$, $I_{in2}$) qui possède la valeur la plus élevée, est délivré par ladite borne de sortie commune (23; $N_3$).

2. Circuit électrique selon la revendication 1, dans lequel la base dudit premier transistor d'entrée ($Q_1$; $Q_{34}$) et la base dudit second transistor d'entrée ($Q_4$; $Q_{47}$) sont formées par une couche semiconductrice de type N (804) sur un substrat semiconducteur de type P (800) et le collecteur dudit premier transistor d'entrée ($Q_1$; $Q_{34}$) et le collecteur dudit second transistor d'entrée ($Q_4$; $Q_{47}$) sont formés respectivement par une première couche semiconductrice de type P (807) et par une seconde couche semiconductrice de type P (809), qui sont formées à l'intérieur de ladite couche semiconductrice de type N (804); avec comme résultat le fait que, de façon équivalente, l'émetteur dudit premier transistor additionnel ($Q_{P1}$) est formé par ladite première couche semiconductrice de type P (807), que, de façon équivalente, l'émetteur dudit second transistor additionnel ($Q_{P4}$) est formé par ladite seconde couche semiconductrice de type P (809), que, de façon équivalente, la base dudit premier transistor additionnel ($Q_{P1}$) et la base dudit second transistor additionnel ($Q_{P4}$) sont formées par ladite couche semiconductrice de type N (804), et que, de façon équivalente, le collecteur dudit premier transistor additionnel ($Q_{P1}$) et le collecteur dudit second transistor additionnel ($Q_{P4}$) sont formés par ledit substrat semiconducteur de type P (800).

3. Circuit expanseur du type à expansion compatible, comprenant:

(a) un premier amplificateur d'entrée (121) pour amplifier un premier signal d'entrée;

(b) un second amplificateur d'entrée (122) pour amplifier un second signal d'entrée;

(c) un premier redresseur (123) pour produire un premier courant redressé à partir d'un signal de sortie à courant alternatif dudit premier amplificateur d'entrée (121);

(d) un second redresseur (124) pour produire un second courant redressé à partir d'un signal de sortie à courant alternatif dudit second amplificateur d'entrée (122);

(e) un détecteur de courant maximum (125) pour produire un signal de sortie qui est proportionnel à la valeur la plus élevée des premier et second courants redressés;

(f) un détecteur de crête (126), dont la borne d'entrée est raccordée à une borne de sortie dudit détecteur de courant maximum (125);

(g) un circuit (128) produisant une constante de temps, dont la borne d'entrée est raccordée à une borne de sortie dudit détecteur de crête (126);

(h) un premier circuit amplificateur à gain variable (134), qui est agencé de telle sorte que sa borne d'entrée est alimentée par le signal de sortie dudit premier amplificateur d'entrée (121) et que son gain est commandé par un signal de sortie dudit circuit (128) produisant une constante de temps, ce qui a pour effet qu'un premier signal de sortie étendu est délivré par sa borne de sortie; et

(i) un second circuit amplificateur à gain variable (135), qui est agencé de telle sorte que sa borne d'entrée est alimentée par le signal de sortie dudit second amplificateur d'entrée (122) et que son gain est commandé par le signal de sortie dudit circuit (128) fournissant une constante de temps, ce qui a pour effet qu'un second signal de sortie étendu est délivré par sa borne de sortie;

caractérisé en ce que ledit détecteur de courant maximum (125) est un circuit conforme à la revendication 1 ou 2, dans lequel ladite première borne d'entrée ($N_1$) est alimentée par le premier courant redressé, tandis que la seconde borne d'entrée ($N_2$) est alimentée par le second courant redressé.

FIG. 1

FIG. 2

FIG. 3

FIG. 4

1

# FIG. 5

Vcc(+10V)
24

Q1    Q2    Q4

Q3    Q5

20    14    15    21

Iin1    23    Iout    Iin2

12kΩ R11    43kΩ R2

R12    50

# FIG. 6

Iin1 ≒ Iin2

A ——— B·— C ———

Iin1 > Iin2    Iin1 < Iin2

ℓ1

ℓ2

0 091 996

## FIG. 7

## FIG. 8

3

## FIG. 9

## FIG. 10

## FIG. 11

FIG. 12A

0 091 996

FIG. 12B